# EUROPEAN PATENT APPLICATION

(11) **EP 1 233 529 A1**
(43) Date of publication of application: **21.08.2002**
(21) Application number: 01958503.3
(22) Date of filing: 27.08.2001
(51) Int. Cl.: H04B 1/44

(54) **COMMUNICATION DEVICE**

(30) Priority: 25.08.2000 JP 2000256040
(71) Applicant: MATSUSHITA ELECTRIC INDUSTRIAL CO., LTD., Kadoma-shi, Osaka 571-8501 (JP)
(72) Inventor: TAMURA, Masahisa, Kanazawa-ku, Yokohama-shi, Kanagawa 236- (JP)
(74) Representative: Grünecker, Kinkeldey, Stockmair & Schwanhäusser Anwaltssozietät
(86) International application number: JP0107302
(87) International publication number: WO02017505

(57) **Abstract**

A configuration, in which switches 107 and 109 are loaded to bias lines 104 and 105, is adopted. It is such structured that a high frequency switch 100 can be changed over at a high speed by closing the switches 107 - 109 to discharge the electric charge accumulated on PIN diodes D1 and D2 at a high speed when turning OFF the PIN diodes D1 and D2.

## Description

### Technical Field

The present invention relates to a communication apparatus provided with a high frequency switch which is used for various high frequency radio apparatus, communication equipment, measuring equipment and the like.

### Background Art

Conventionally, some communication apparatus such as high frequency radio apparatus, communication equipment, high frequency measuring equipment or the like use a high frequency switch for branching or shutting down high frequency signal. A communication apparatus like that is, for example, disclosed in Japanese Unexamined Patent Application Publication No.8-228165 (Antenna switch control apparatus in radio communication apparatus). In this communication apparatus, it is adapted so that a high frequency signal can be branched to two paths by changing over a high frequency switch to supply bias current to a first PIN diode and a second PIN diode. The first PIN diode and the second PIN diode are formed, for example, by utilizing a process of bipolar transistor using a compound semiconductor.

However, a bipolar element using a PN junction has such an essential problem that the turn-OFF thereof delays due to an influence of base-accumulated electric charge when the element shifts from the ON-state to the OFF-state. As the frequency of the communication signal becomes higher, it becomes more difficult to ignore the delay of turn-OFF of the switch (bipolar switch) using the PN junction of the bipolar element.

### Disclosure of Invention

An object of the present invention is to provide a communication apparatus which is capable of switching exciting path swiftly to change over the high frequency signal at a high speed.

The object can be achieved by a communication apparatus which comprises a first switch and a second switch that connect control lines to a bias power supply of a high frequency switch having switches loaded in parallel at the respective portions a predetermined wavelength away, respectively, from a branch point of a common terminal toward the respective terminals and control lines connected in parallel to the respective signal lines to supply a bias, respectively, for controlling ON/OFF operation of said switches; and a third switch and a fourth switch that connect said control lines to the respective ground potentials.

According to an embodiment of the communication apparatus of the present invention, a pull-down circuit for forcibly pulling out residual electric charge of a switching diode utilizing a bipolar element is provided. The pull-down circuit is composed of an active element (a transistor) which has an amplification facility.

According to another embodiment of the communication apparatus of the present invention, a bias transistor for turning ON the switching diode utilizing the bipolar element and a pull-down transistor for forcibly pulling out accumulated electric charge of the switching diode are provided, and further the level of a control signal, which turns ON/OFF the bias transistor, is inverted by an inverter (an active element having amplification facility), and the foregoing pull-down transistor is driven by the control signal of which level is inverted.

When the level of the control signal is inverted to shift the bias transistor from the ON-state to the OFF-state, the level of an output signal of the inverter is inverted swiftly by detecting the inversion, thereby the pull-down transistor turns ON swiftly to pull out the anode residual electric charge of the switching diode. Accordingly, the switching diode turns OFF swiftly resulting in a remarkable increase of the switching speed.

### Brief Description of Drawings

FIG. 1 is a circuit diagram of a high frequency switch according to a first embodiment of the present invention;
FIG. 2 is a circuit diagram of a high frequency switch according to a second embodiment of the present invention;
FIG. 3 is a circuit diagram of a high frequency switch according to a third embodiment of the present invention;
FIG. 4 is a block diagram of a radio communication apparatus according to a fourth embodiment of the present invention;
FIG. 5 is a block diagram of a radio communication apparatus according to a fifth embodiment of the present invention;
FIG. 6 is a block diagram of a radio communication apparatus according to a sixth embodiment of the present invention;
FIG. 7 is a block diagram of a radio communication apparatus according to a seventh embodiment of the present invention;
FIG. 8 is a block diagram of a radio communication apparatus according to an eighth embodiment of the present invention;
FIG. 9 is a block diagram of a radio communication apparatus according to a ninth embodiment of the present invention;
FIG. 10 is a diagram illustrating switching of a PIN diode;
FIG. 11A is a circuit diagram illustrating a concrete circuit configuration of an essential portion of a high frequency switch which does not use the present invention (comparative example);
FIG. 11B is a diagram illustrating turn-OFF characteristics of a switching diode shown in FIG. 11A;
FIG. 11C is a circuit diagram illustrating a concrete circuit configuration of an essential portion of a high frequency switch used in a communication apparatus of the present invention; and
FIG. 11D is a diagram illustrating turn-OFF characteristics of the switching diode shown in FIG. 11C.

### Best Mode for Carrying Out the Invention

Now, referring to attached drawings, a detailed description of embodiments of the present invention will be made below.

### (First embodiment)

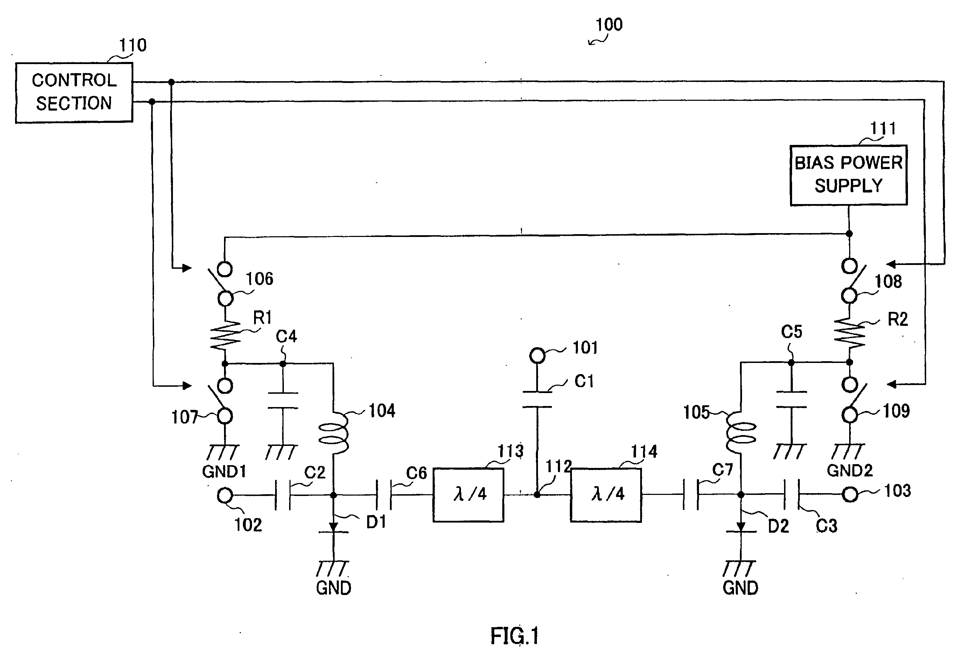

FIG. 1 is a circuit diagram of a high frequency switch according to a first embodiment of the present invention. In the first embodiment, PIN diodes D1 and D2 are used as a first and second switching element respectively.

A high frequency switch 100 is adapted so as to be connected from a branch point 112 of a path from a first terminal 101 interposed by a DC cut capacitor C1 to PIN diodes D1 and D2, of which one end is grounded respectively, loaded in parallel being interposed by ./4 wavelength lines 113 and 114, which have a length of 1/4 wavelength at the central-frequency, and DC cut capacitors C6, C7 respectively, and further connected to a second terminal 102 and a third terminal 103 being interposed by DC cut capacitors C2 and C3 respectively.

The ./4 wavelength lines 113 and 114 have a line length of 1/4 wavelength . of a main high frequency signal, which passes through the transmission line, thereby input/output impedance is made to match so as to prevent generation of reflection wave.

To the PIN diodes D1 and D2, bias current is supplied from a bias power supply 111 via bias lines 104 and 105, resistances R1 and R2 and switches 106 and 108, respectively. The bias lines 104, 105 have a length of 1/4 wavelength at the central-frequency, and are adapted so as to be short-circuited in a manner of high frequency via capacitors C4 and C5 which produce low impedance, respectively, with respect to the central-frequency.

Further, between the bias lines 104 and 105 and grounds GND1 and GND2, switches 107 and 109 are loaded. The switches 106, 107, 108 and 109 are adapted so as to be subjected to ON/OFF control by a control section 110.

Now, a case, in which the switches 107 and 108 are ON, and the switches 106 and 109 are OFF, will be considered. The PIN diode D2 is in the ON-state being supplied with bias current via the switch 108, the resistance R2 and the bias line 105.

On the other hand, since the switch 107 is closed, the PIN diode D1 is not supplied with bias current and is in the OFF-state. At this time, since the impedance on the side of second terminal 102 viewed from the branch point 112 is low impedance; while the impedance on the side of the third terminal 103 viewed therefrom is high impedance, a high frequency signal is transmitted between the first terminal 101 and the second terminal 102. Here, it is adapted so that, the second terminal 102 or the third terminal 103 is connected to the branch point 112 via the ./4 wavelength line 113 or the ./4 wavelength line 114, the capacitors C6 and C7 or capacitors C2 and C3.

Then, a case where the above-described state changes into a state in which switches 106 and 109 are ON, and switches 107 and 108 are OFF will be considered. When the PIN diodes D1 and D2 are in a state of forward bias, it is a state that electric charge corresponding to the forward current has been accumulated, and it is known that the time required for discharging the electric charge is the time required for the PIN diodes D1 and D2 to turn OFF.

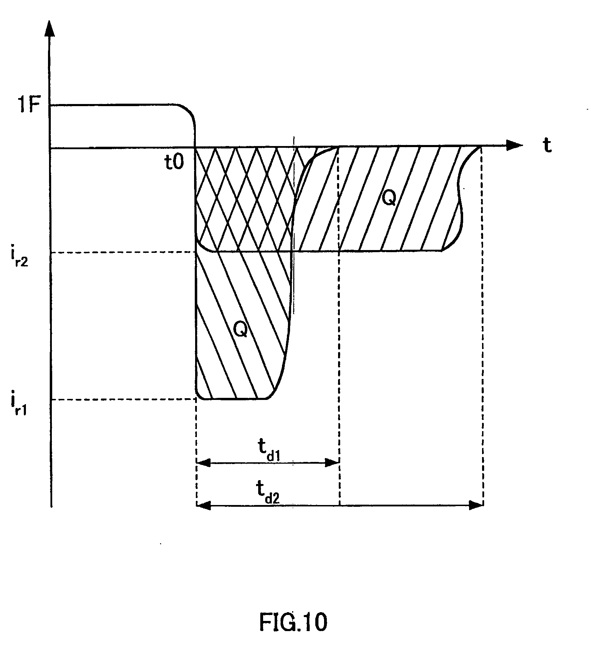

As shown in FIG. 10 which will be described later, it is possible to discharge the accumulated electric charge at a higher speed by obtaining a large instantaneous reverse current. In a high frequency switch 100 in FIG. 1, a large instantaneous reverse current is obtained by turning ON the switch 109, and the electric charge accumulated in the PIN diode D2 is discharged at a high speed. A detailed description about that will be made in a third embodiment.

As described above, according to the first embodiment, it is enabled to provide the high frequency switch 100 that is capable of performing a high speed changeover by setting up switches 106-109 that provide a path for discharging the electric charge accumulated in the PIN diode D1 at a high speed.

### (Second embodiment)

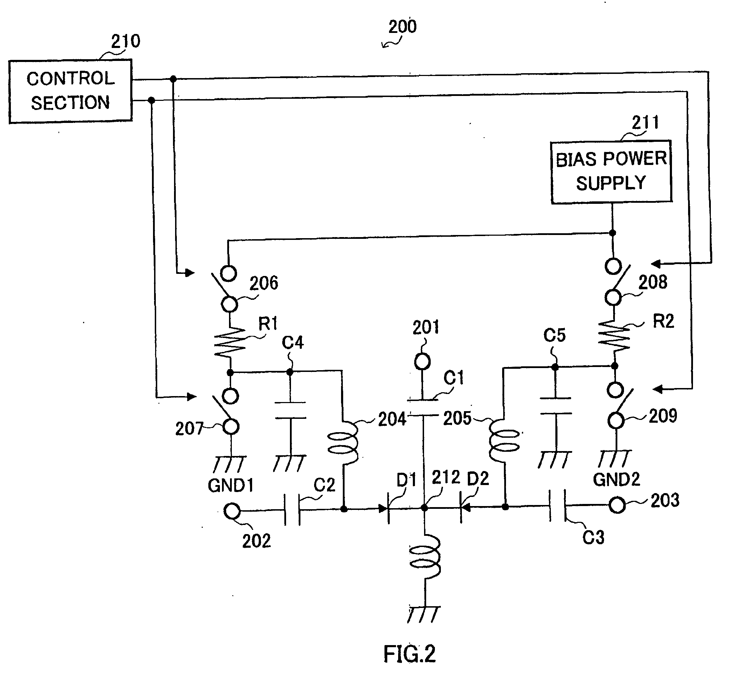

FIG. 2 is a circuit diagram of a high frequency switch according to a second embodiment of the present invention. In the second embodiment also, PIN diodes D1 and D2 are used as a first and a second switching element respectively.

A high frequency switch 200 is adapted so that PIN diodes D1 and D2 are loaded in series from a branch point 212 of a path from a first terminal 201 being interposed by a DC cut capacitor C1 and connected to a second terminal 202 and a third terminal 203 being interposed by DC cut capacitors C2 and C3 respectively.

To the PIN diodes D1 and D2, bias current is supplied from a bias power supply 211 via bias lines 204 and 205, resistances R1 and R2 and switches 206 and 208. The bias lines 204 and 205 have a length of 1/4 wavelength at the central-frequency, and are adapted so as to be short-circuited in a manner of high frequency via capacitors C4 and C5 which produce low impedance, respectively, with respect to the central-frequency.

Further, between the bias lines 204 and 205 and grounds GND1 and GND2, switches 207 and 209 are loaded. The switches 206, 207, 208 and 209 are adapted so as to be subjected to ON/OFF control by a control section 210.

Then, a case, in which the switches 207 and 208 are ON, and the switches 206 and 209 are OFF, will be considered. The PIN diode D2 is in the ON-state being supplied with bias current via the switch 208, the resistance R2 and the bias line 205. On the other hand, since the switch 207 is closed, the PIN diode D1 is not supplied with the bias current and is in the OFF-state. Accordingly, the high frequency signal can be transmitted between the first terminal 201 and the third terminal 203.

Then, a case where the above-described state changes into a state, in which switches 206 and 209 are ON and switches 207 and 208 are OFF, will be considered. A large instantaneous reverse current is obtained by turning ON the switch 209, and the electric charge accumulated in the PIN diode D2 is discharged at a high speed.

As described above, according to the second embodiment, it is enabled to provide the high frequency switch 200 that is capable of performing a high speed changeover by setting up the switches 207 and 209 as the paths for discharging the electric charge accumulated in the PIN diodes D1 and D2 at a high speed. Further, the circuit configuration of the second embodiment has such an advantage that, since the ./4 wavelength lines 113 and 114 in FIG. 1 are not used as the signal transmission lines, the circuit size can be made smaller.

### (Third embodiment)

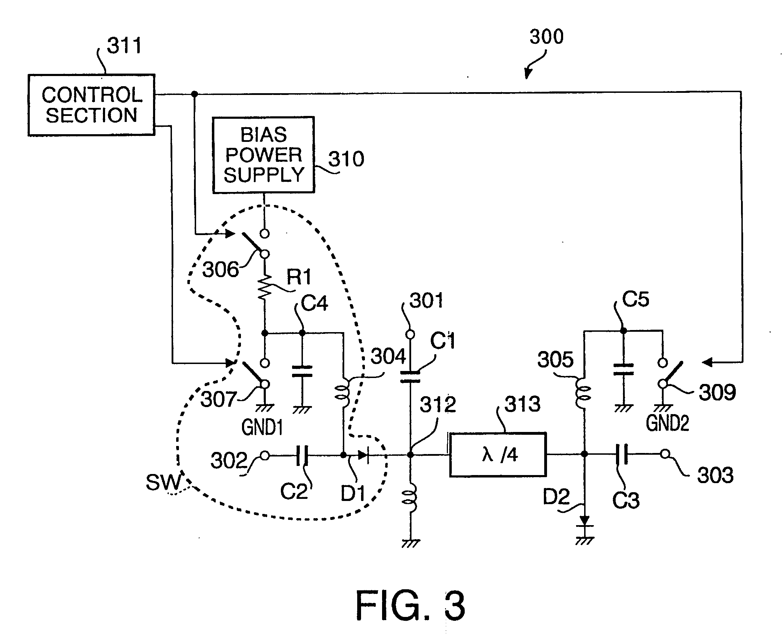

FIG. 3 is a circuit diagram of a high frequency switch according to a third embodiment of the present invention. In the third embodiment also, PIN diodes D1 and D2 are used as first and second switching elements.

A high frequency switch 300 is adapted so as to be connected from a branch point 312 of a path from a first terminal 301 interposed by a DC cut capacitor C1, to a PIN diode D1 loaded in series and connected to a second terminal 302 being interposed by a DC cut capacitor C2; and connected to a PIN diode D2 loaded in parallel, of which one end is grounded being interposed by a ./4 wavelength line 313 having 1/4 wavelength in length at the central-frequency; and further connected to a third terminal 303 being interposed by a ./4 wavelength line 313 having 1/4 wavelength in length at the central-frequency and a DC cut capacitor C3.

It is adapted so as to connect a bias power supply 310 to the PIN diode D1 being interposed by a bias line 304, a resistance R1 and a switch 306; and it is adapted so as to connect a bias line 305 to the PIN diode D2.

The bias lines 304 and 305 have a length of 1/4 wavelength at the central-frequency, and are short-circuited in a manner of high frequency via capacitors C4 and C5 which produce low impedance, respectively, with respect to the central-frequency. And, between the bias lines 304 and 305 and grounds GND1 and GND2, switches 307 and 309 are loaded. The switches 306, 307 and 309 are adapted so as to be subjected to ON/OFF control by a control section 311.

A case where the switch 306 is ON and the switches 307 and 309 are OFF will be considered. The PIN diode D1 is in the ON-state being supplied with the bias current from the bias power supply 310 via the switch 306, the resistance R1 and the bias line 304. Further, the PIN diode D2 is in the ON-state being supplied with the bias current via the 1/4 wavelength line 313.

At this time, since the impedance on the side of second terminal 302 viewed from the branch point 312 is low impedance; while the impedance on the side of third terminal 303 viewed therefrom is high impedance, the high frequency signal is transmitted between the first terminal 301 and the second terminal 302.

Then, a case where the above-described state changes into a state, in which switch 306 is OFF and switches 307 and 309 are ON, will be considered. A large instantaneous reverse current is obtained by turning ON the switches 307 and 309, and the electric charge accumulated in the PIN diodes D1 and D2 is discharged at a high speed.

And the PIN diodes D1 and D2 become the OFF-state. At this time, since the impedance on the side of second terminal 302 viewed from the branch point 312 is high impedance; while the impedance on the side of third terminal 303 viewed therefrom is low impedance, the high frequency signal can be transmitted between the first terminal 301 and the second terminal 303.

As described above, according to the third embodiment, it is enabled to provide the high frequency switch 300 that is capable of performing a high speed changeover by setting up the switches 307 and 309 as the paths for discharging the electric charge accumulated in the PIN diodes D1 and D2 at a high speed.

Further, since the circuit configuration of the third embodiment uses only one 1/4 wavelength line 313 as the signal transmission line, the third embodiment has such an advantage that the size of the circuit can be made smaller compared with the circuit size of the first embodiment. Furthermore, in the first and second embodiments, either one of diodes is always supplied with the bias current; in the third embodiment, since the bias current is not supplied when the third terminal 303 side is ON, the third embodiment has such an advantage also that the power consumption can be reduced.

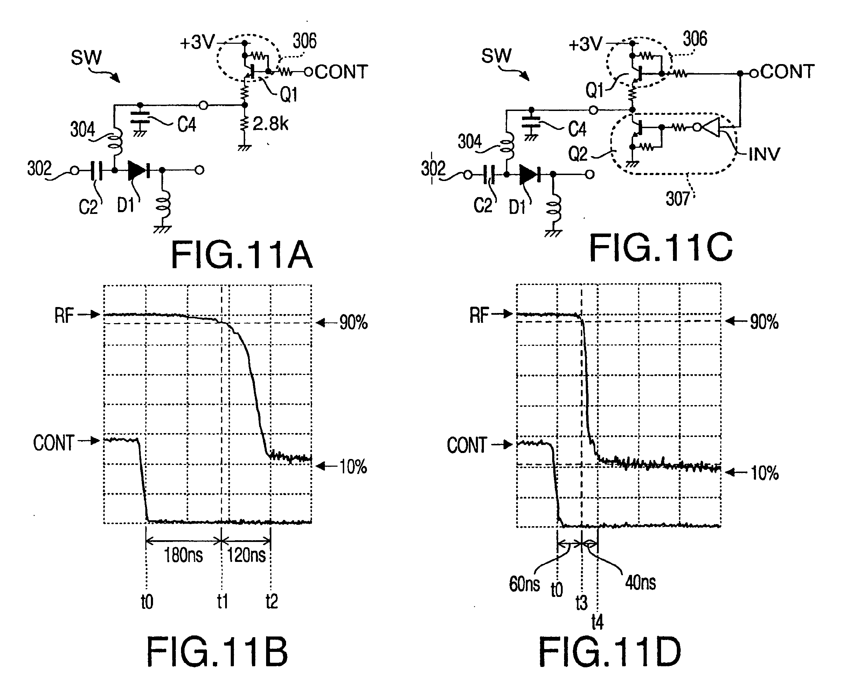

FIG. 11C shows an example of a concrete circuit configuration of a portion SW indicated being circled by a dotted line in FIG. 3. FIG. 11D shows turn-OFF characteristics of a switching diode D1 in a circuit shown in FIG. 11C. FIG. 11A shows an example of a circuit configuration in which the present invention is not applied to, and FIG. 11B shows turn-OFF characteristics of a switching diode D1 in a circuit shown in FIG. 11A.

In FIG. 11A and FIG. 11C, the capacity of a capacitor C4 is 18pF, and when bias transistor Q1 is ON, the electric charge accumulated in capacitor C4 is 20pC. Also, when the transistor Q1 is ON, the current, which flows through an inductance 304, is 10.A and the electric charge accumulated in the switching diode is 450pC. And the collector potential (power supply voltage) of the bias transistor Q1 is +3V.

In the circuit in FIG. 11C, when the control signal (CONT) becomes high level, the bias transistor Q1 (NPN transistor) turns ON and the switching diode D1 turns ON. Owing to that, the input impedance of the transmission path viewed from the terminal 302 becomes low. On the other hand, when the control signal (CONT) becomes high level, a pull-down transistor Q2 (NPN transistor) turns OFF.

Then, when the control signal (CONT) becomes low level, although the bias transistor Q1 shifts into the OFF-state; actually, due to an influence of a base accumulated electric charge of the bias transistor Q1, turn-OFF of the bias transistor Q1 delays. Likewise, turn-OFF of the switching diode D1 also delays due to an influence of a residual electric charge of anode.

That is to say, in a circuit configuration shown in FIG. 11A, as shown in FIG. 11B, it takes 180ns until the turn-OFF operation of the switching diode D1 is initiated (at a point of time t2) after the level of the control signal (CONT) has inverted (at a point of time t1), furthermore, it takes 120ns until the switching diode D1 turns OFF. That is to say, a large turn-OFF delay of total 300ns is resulted in.

To the contrary, in a circuit shown in FIG. 11C, when the control signal (CONT) becomes low level, the output level of a inverter (an element utilizing a transistor which has an amplification facility) INV changes swiftly from a low level to a high level at a point of time when the input level of the inverter INV becomes lower than a threshold value. Owing to this, a pull-down transistor Q2 swiftly turns ON and forcibly absorbs emitter current flowing out from a bias transistor Q1, which has not completely turned OFF, and residual anode electric charge of the switching transistor D1. Accordingly, the switching transistor D1 turns OFF swiftly.

As shown in FIG. 11D, in the case of the circuit in FIG. 11C, the turn-OFF operation of the switching transistor D1 is initiated after 60ns (at a point of time t3) from a point of time t0 when the level of the control signal has inverted. And the switching diode D1 turns OFF after 40ns (at a point of time t4)from a point of time t3. Since the turn-OFF delay time of the circuit shown in FIG. 11C is total 100ns, the turn-OFF delay is reduced to 1/3 of that of the circuit shown in FIG. 11A.

As shown in FIG. 10, in a case of the circuit in FIG. 11A, the residual electric charge of the switching diode D1 is extinguished by supplying discharge current ir2 for a period of time td2 from a point of time t0. On the other hand, in a case of the circuit in FIG. 11C, the residual electric charge of the switching diode D1 is swiftly pulled out by supplying discharge current ir1 for a period of time td1 from a point of time 10.

As described above, it is enabled to make the turn-OFF of the switching diode D1 be largely faster by connecting the bias transistor Q1 and the pull-down transistor Q2 in a manner of totem pole connection (a method of connecting the respective emitter-collector paths of each transistor in series) and by structuring so as to drive the pull-down transistor Q2 by the inverter (active element) INV, as shown in FIG. 11C.

### (Fourth embodiment)

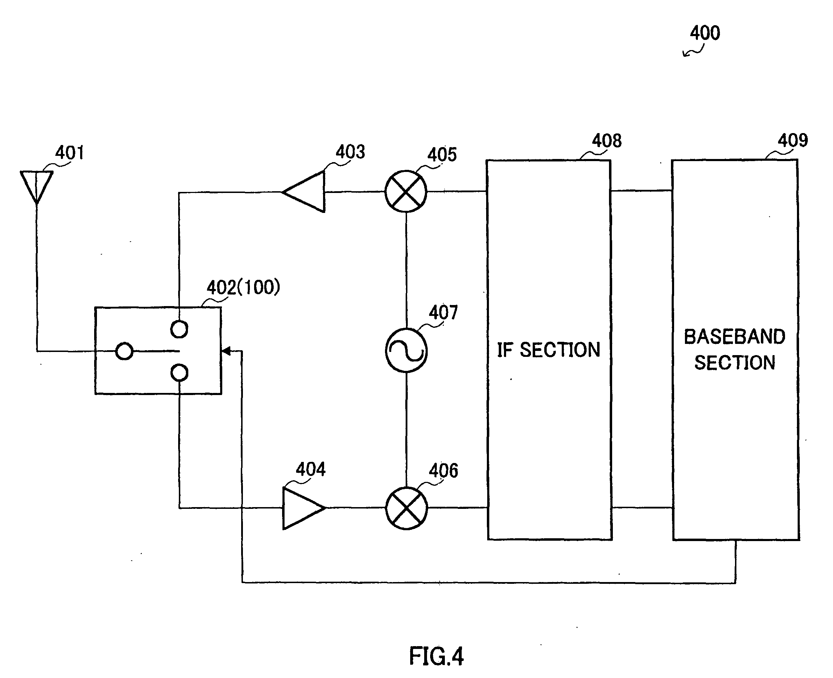

FIG. 4 is a block diagram of a radio communication apparatus according to a fourth embodiment of the present invention. In a radio communication apparatus 400, the high frequency switch 100, which has been described in the first embodiment, is used as a transmission/reception changeover switch 402.

When carrying out a transmission, a signal output from a base band section 409 is modulated and amplified by an IF section 408, subjected to an up-conversion by an up-mixer 405 using a local signal output from a local signal source 407, and amplified by a power amplifier 403. The transmitting side in a transmission/reception changeover switch 402 is turned ON by means of control from the base band section 409 to output a transmission signal to an antenna 401.

When carrying out a reception, the receiving side in the transmission/reception changeover switch 402 is turned ON by means of the control from the base band section 409, and a received signal received by the antenna 401 is input to a low-noise amplifier 404, subjected to a down-conversion by a down mixer 406, amplified and demodulated by the IF section 408, and subjected to a processing by the base band section 409.

As described above, according to the fourth embodiment, it is enabled to provide the radio communication apparatus 400 that is capable of performing a high speed changeover by using the high frequency switch 100, which has been described in the first embodiment, as the transmission/reception changeover switch.

### (Fifth embodiment)

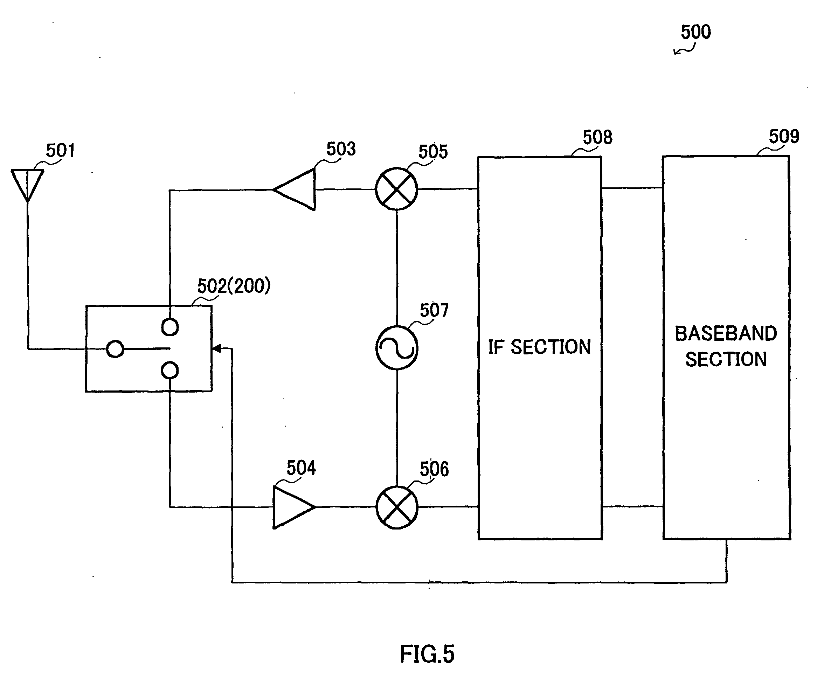

FIG. 5 is a block diagram of a radio communication apparatus according to a fifth embodiment of the present invention. In a radio communication apparatus 500, the high frequency switch 200, which has been described in the second embodiment, is used as a transmission/reception changeover switch 502.

When carrying out a transmission, a signal output from a base band section 509 is modulated and amplified by an IF section 508, subjected to an up-conversion by an up-mixer 505 using a local signal output from a local signal source507, and amplified by a power amplifier 503.

As described above, in the radio communication apparatus 500, the transmitting side in the transmission/reception changeover switch 502 is turned ON by means of control from the base band section 509 to output a transmission signal to an antenna 501.

When carrying out a reception, the receiving side in the transmission/reception changeover switch 502 is turned ON by means of control from the base band section 509, and a received signal received via the antenna 501 is input to a low-noise amplifier 504, subjected to a down-conversion by a down-mixer 506, amplified and demodulated by the IF section 508 and subjected to a processing by the base band section 509.

As described above, according to the fifth embodiment, it is enabled to provide the radio communication apparatus 500 that is capable of performing a high speed changeover by using the high frequency changeover switch 200, which has been described in the second embodiment, as the transmission/reception changeover switch.

### (Sixth embodiment)

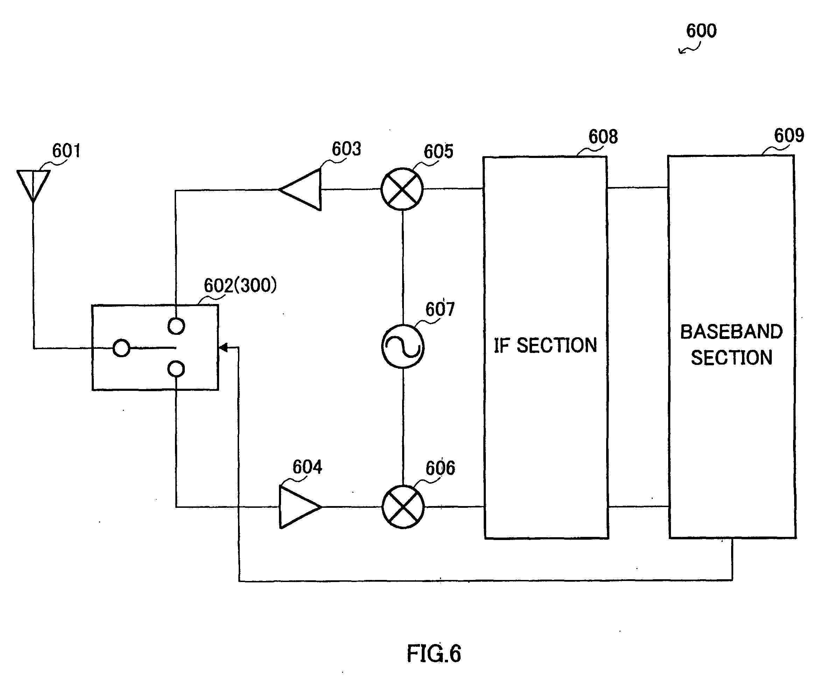

FIG. 6 is a block diagram of a radio communication apparatus according to a sixth embodiment of the present invention. As a transmission/reception changeover switch 602, the high frequency switch, which has been described in the third embodiment, is used. When carrying out a transmission, a signal output from a base band section 609 is modulated and amplified by an IF section 608, subjected to an up-conversion by an up-mixer 605 using a local signal output from a local signal source 607, and is amplified by a power amplifier 603. The transmitting side in the transmission/reception changeover switch 602 is turned ON by means of control from the base band section 609 to output a transmission signal to an antenna 601.

When carrying out a reception, the receiving side in the transmission/reception changeover switch 602 is turned ON by means of control from the base band section 609, and a received signal received via the antenna 601 is input to a low-noise amplifier 604, subjected to a down-conversion by a down-mixer 606, amplified and demodulated by the IF section 608, and subjected to a processing by the base band section 609.

As described above, according to the sixth embodiment, it is enabled to provide the radio communication apparatus having a small size and reduced power consumption that is capable of performing a high speed changeover by using the high frequency changeover switch 300, which has been described in the third embodiment, as the transmission/reception changeover switch 602.

In the above-described first embodiment to sixth embodiment, although a configuration, in which the level detection is performed using a base band IQ signal after orthogonal demodulation, has been described, a configuration, in which the level before orthogonal demodulation is detected, may be adopted.

### (Seventh embodiment)

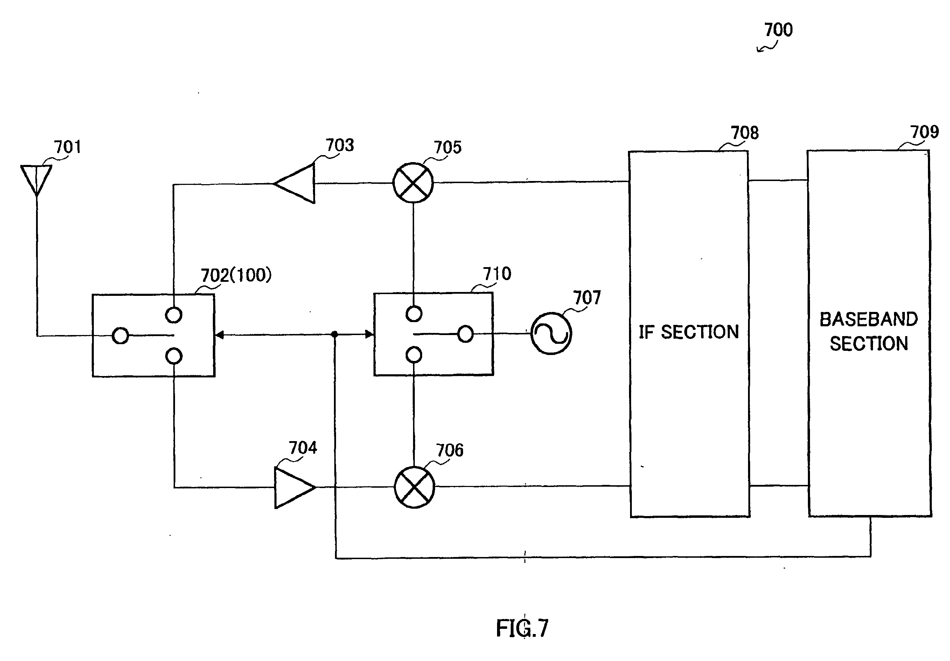

FIG. 7 is a block diagram of a radio communication apparatus according to a seventh embodiment of the present invention. As a transmission/reception changeover switch 702 and a local signal changeover switch 710, the high frequency switch 100, which has been described in the first embodiment, is used.

When carrying out a transmission, a signal output from a base band section 709 is modulated and amplified by an IF section 708. The transmitting side in the local signal changeover switch 710 is turned ON by means of control from the base band section 709, a local signal is supplied from a local signal source 707 to up-mixer 705, and a transmission signal is subjected to an up-conversion by the up-mixer 705 and amplified by a power amplifier 703. The transmitting side in the transmission/reception changeover switch 702 is turned ON by means of control from the base band section 709, and the transmission signal is output to an antenna 701.

When carrying out reception, the receiving side in the transmission/reception changeover switch 702 is turned ON by means of control from the base band section 709, and a received signal received via the antenna 701 is input to a low-noise amplifier 704. The receiving side in the local signal changeover switch 710 is turned ON by means of control from the base band section 709 to supply a local signal from the local signal source 707 to a down-mixer 706, and the received signal is subjected to an down-conversion by the down-mixer 706, amplified and demodulated by the IF section 708 and subjected to a processing by the base band section 709.

As described above, according to the seventh embodiment, it is enabled to provide a radio communication apparatus 700 that is capable of performing a high speed changeover and providing a good isolation between the transmission and reception by using the high frequency switch 100, which has been described in the first embodiment, as the transmission/reception changeover switch 702 and the local signal changeover switch 710.

### (Eighth embodiment)

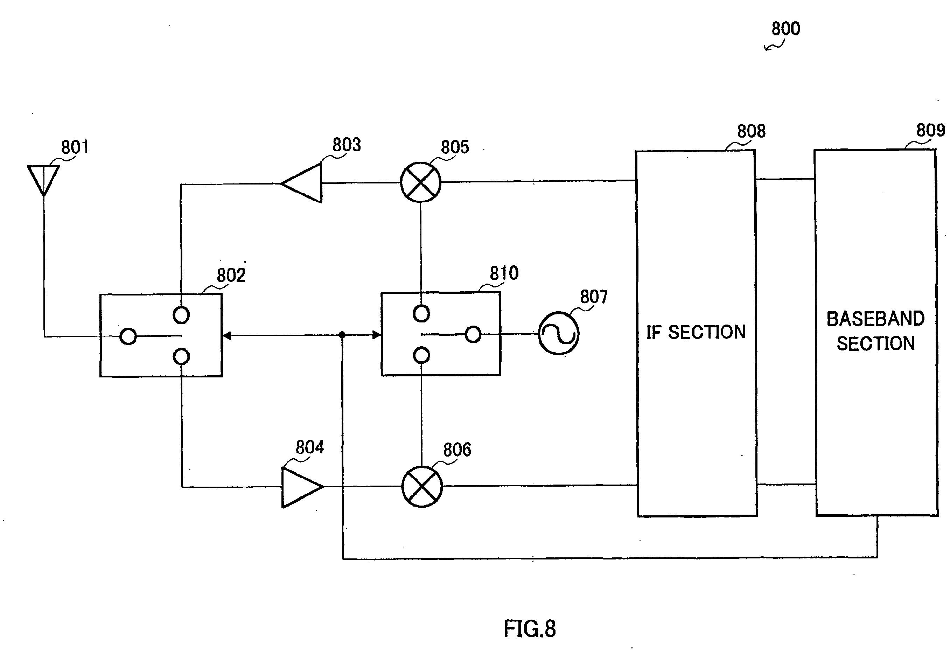

FIG. 8 is a block diagram of a radio communication apparatus according to an eighth embodiment of the present invention. As a transmission/reception changeover switch 802 and a local signal changeover switch 810, the high frequency switch 200, which has been described in the second embodiment, is used.

When carrying out a transmission, a signal output from a base band section 809 is modulated and amplified by an IF section 808. The transmitting side in the local signal changeover switch 810 is turned ON by means of control from the base band section 809, a local signal is supplied from a local signal source 807 to an up-mixer 805, a transmission signal is subjected to an up-conversion by the up-mixer 805 and amplified by a power amplifier 803. The transmitting side in the transmission/reception changeover switch 802 is turned ON by means of control from the base band section 809, and the transmission signal is output to an antenna 801.

When carrying out a reception, the receiving side in the transmission/reception changeover switch 802 is turned ON by means of control from the base band section 809, and a received signal received via the antenna 801 is input to a low-noise amplifier 804. The receiving side in the local signal changeover switch 810 is turned ON by means of control from the base band section 809, a local signal is supplied from the local signal source 807 to a down-mixer 806, and the received signal is subjected to a down-conversion by the down-mixer 806, amplified and demodulated by the IF section 808 and subjected to a processing by the base band section 809.

As described above, according to the eighth embodiment, it is enabled to provide a radio communication apparatus 800 having a small size that is capable of performing a high speed changeover and providing a good isolation between the transmission and reception by using the high frequency switch 200, which has been described in the second embodiment, as the transmission/reception changeover switch 802 and the local signal changeover switch 810.

### (Ninth embodiment)

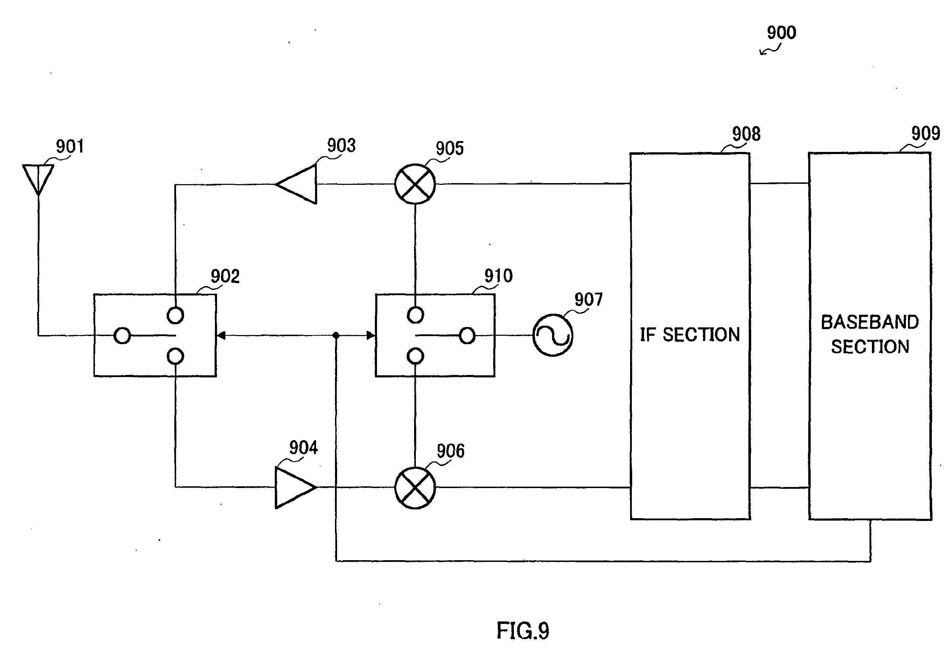

FIG. 9 is a block diagram of a radio communication apparatus according to an ninth embodiment of the present invention. As a transmission/reception changeover switch 902 and a local signal changeover switch 910, the high frequency switch 300, which has been described in the third embodiment, is used.

When carrying out a transmission, a signal output from a base band section 909 is modulated and amplified by an IF section 908. The transmitting side in the local signal changeover switch 910 is turned ON by means of a control from the base band section 909, a local signal is supplied from a local signal source 907 to an up-mixer 905, and a transmission signal is subjected to an up-conversion by the up-mixer 905 and amplified by a power amplifier 903. The transmitting side in the transmission/reception changeover switch 902 is turned ON by means of control from the base band section 909, and the transmission signal is output to an antenna 901.

When carrying out a reception, the receiving side in the transmission/reception changeover switch 902 is turned ON by means of control from the base band section 909, and a received signal received via the antenna 901 is input to a low-noise amplifier 904. The receiving side in the local signal changeover switch 910 is turned ON by means of control from the base band section 909, a local signal is supplied from a local signal source 907 to a down-mixer 906, and the received signal is subjected to a down-conversion by the down-mixer 906, amplified and demodulated by the IF section 908, and subjected to a processing by the base band section 909.

As described above, according to the ninth embodiment, it is enabled to provide a radio communication apparatus 900 having a small size that is capable of performing a high speed changeover and providing a good isolation between the transmission and reception by using the high frequency switch 300, which has been described in the third embodiment as the transmission/reception changeover switch 902 and the local signal changeover switch 910.

In the above-described first embodiment to ninth embodiment, although a configuration, in which the PIN diode is used as a switching element, another switching element such as an FET, bipolar transistor or the like may be used.

In order to achieve the object as described above, the communication apparatus of the present invention is structured so as to comprise a high frequency switch comprising switches loaded in parallel at the respective portions a predetermined wavelength away, respectively, from a branch point of a common terminal toward the respective terminals and control lines connected in parallel to respective signal lines to supply a bias, respectively, for controlling ON/OFF operation of the switches, wherein the high frequency switch comprises a first switch and a second switch that connect the control lines to the bias power supply, and a third switch and a fourth switch that connect the control lines to the respective ground potentials.

Owing to the configuration as described above, it is enabled to connect the control lines to the bias power supply of the high frequency switch provided with the control lines connected in parallel to the respective signal lines to supply a bias, respectively, for controlling ON/OFF operation of said switches loaded in parallel at the respective portions a predetermined wavelength away, respectively, from the branch point of a common terminal toward the respective terminals, to connect the control lines to the ground potentials; thereby it is enabled to switch the exciting path swiftly to change over the high frequency signal at a high speed.

The communication apparatus of the present invention is structured so as to comprise a high frequency switch comprising a first switching element and a second switching element loaded in parallel at the respective portions 1/4 wavelength away, respectively, from a branch point of a common terminal toward a first terminal and a second terminal, respectively, and a first control line and a second control line connected in parallel to each signal line to supply a bias, respectively, for controlling ON/OFF operation of the first switching element and the second switching element, wherein the high frequency switch comprises a first switch and a second switch that connect the first control line and the second control line to the bias power supply, and a third switch and a fourth switch that connect the first control line and the second control line to the respective ground potentials.

Owing to the configuration as described above, it is enabled to connect the first control line and the second control line to the bias power supply of the high frequency switch comprising the first switching line and the second switching line connected in parallel to each signal line to supply a bias, respectively, for controlling ON/OFF operation of the first switching element and the second switching element loaded in parallel at the respective portions 1/4 wavelength away, respectively, from the branch point of the common terminal toward the first terminal and the second terminal, respectively, to connect the control lines to the respective ground potentials; thereby it is enabled to switch the exciting path swiftly to change over the high frequency signal at a high speed.

The communication apparatus of the present invention is structured so as to comprise a high frequency switching apparatus comprising a first switching element interposed in series in a signal line connecting a common terminal and a first terminal, a second switching element interposed in series in a signal line connecting said common terminal and a second terminal, and a first control line and a second control line connected in parallel to each signal line to supply a bias, respectively, for controlling ON/OFF operation of the first switching element and the second switching element, wherein the high frequency switch comprises a first switch and a second switch that connect the first control line and the second control line to the bias power supply, and a third switch and a fourth switch that connect the first control line and the second control line to the respective ground potentials.

Owing to the configuration as described above, it is enabled, in the high frequency switching apparatus comprising the first control line and the second control line connected in parallel to each signal line to supply a bias for controlling ON/OFF operation of the first switching element interposed in series in the signal line connecting the common terminal and the first terminal and the second switching element interposed in series in the signal line connecting the common terminal and the second terminal, to connect the first control line and the second control line to the bias power supply, and the first control line and the second control line to the respective ground potentials; thereby it is enabled to switch the exciting path swiftly to change over the high frequency signal at a high speed.

The communication apparatus of the present invention is structured so as to comprise a high frequency switch comprising a first switching element interposed in series in a signal line connecting a common terminal and a first terminal, a second switching element loaded in parallel at portion 1/4 wavelength away from a branch point of a common terminal toward a second terminal, and a first control line connected in parallel to the signal line to supply a bias for controlling ON/OFF operation of the first switching element, wherein the high frequency switch comprises a first switch that connects the first control line to the bias power supply, a second switch that connects the first control line to a ground potential, a second control line connected in parallel to the second switching element, a capacitor that grounds the second control line so as to correspond to a high frequency, and a second switch that connects the control line to a ground potential.

Owing to the configuration as described above, it is enabled, in a high frequency switch comprising a first switching element interposed in series in a signal line connecting a common terminal and a first terminal, a second switching element loaded in parallel at portion 1/4 wavelength away from a branch point of a common terminal toward a second terminal, and a first control line connected in parallel to the signal line to supply a bias for controlling ON/OFF operation of the first switching element, to connect a first switch that connects the first control line to the bias power supply, a second switch that connects the first control line to the ground potential, a second control line connected in parallel to the second switching element, a capacitor that connects the second control line so as to correspond to a high frequency, and the control line to the ground potential; thereby it is enabled to switch the exciting path swiftly to change over the high frequency signal at a high speed.

The communication apparatus of the present invention is structured so as to comprise a high frequency switch comprising a first switching element interposed in series in a signal line connecting a common terminal and a first terminal, a second switching element loaded in parallel at portion 1/4 wavelength away from a branch point of a common terminal toward a second terminal, and a first control line connected in parallel to the signal line to supply a bias for controlling ON/OFF operation of said first switching element; wherein the high frequency switch comprises a first switch that connects the first control line to the bias power supply, a second switch that connects the first control line to a ground potential, a second control line connected in parallel to the second switch, a capacitor that connects the second control line so as to correspond to a high frequency, a second switch that connects the control line to the ground potential, and a transmission/reception switching means which commonly uses the high frequency switch.

Owing to the configuration as described above, it is enabled, in a high frequency switch comprising a first switching element interposed in series in a signal line connecting a common terminal and a first terminal, a second switching element loaded in parallel at portion 1/4 wavelength away from a branch point of a common terminal toward a second terminal, and a first control line connected in parallel to the signal line to supply a bias for controlling ON/OFF operation of the first switching element, to connect a first switch that connects the first control line to the bias power supply, a second switch that connects the first control line to the ground potential, a second control line connected in parallel to the second switching element, a capacitor that connects the second control line so as to correspond to a high frequency, and the control line to the ground potential; thereby it is enabled to switch the exciting path swiftly to change over the high frequency signal at a high speed.

The communication apparatus of the present invention can be structured so as to comprise a high frequency comprising a first switching element interposed in series in a signal line connecting a common terminal and a first terminal, a second switching element loaded in parallel at portion 1/4 wavelength away from a branch point of a common terminal toward a second terminal, and a first control line connected in parallel to the signal line to supply a bias for controlling ON/OFF operation of the first switching element, wherein the high frequency switch comprises a first switch that connects the first control line to a bias power supply, a second switch that connects the first control line to a ground potential, a second control line connected in parallel to the second switching element, a capacitor that connects said second control line so as to correspond a high frequency, a second switch that connects the control line to a ground potential, and a switch for switching a local signal which commonly uses the high frequency switch.

Owing to the configuration as described above, it is enabled, in the high frequency switch comprising the first control line connected in parallel to the signal line to supply a bias for controlling ON/OFF operation of the first switching element interposed in series in the signal line connecting the common terminal and a first terminal and of the second switching element loaded in parallel at portion 1/4 wavelength away from a branch point of a common terminal toward a second terminal, to connect the first control line to a bias power supply, to connect the first control line to the ground potential, to connect the second control line in parallel to the second switching element, to connect the second control line to the capacitor so as to correspond to a high frequency, to connect the control line to the ground potential, to commonly use the high frequency switch as a switch for switching a local signal; thereby it is enabled to switch the exciting path swiftly to change over the high frequency signal at a high speed.

The mobile communication apparatus of the present invention is structured so as to comprise a high frequency switch comprising a first switching element interposed in series in a signal line connecting a common terminal and a first terminal, a second switching element loaded in parallel at portion 1/4 wavelength away from a branch point of a common terminal toward a second terminal, and a first control line connected in parallel to a first signal line to supply a bias for controlling ON/OFF operation of the first switching element, wherein the high frequency switch comprises a first switch that connect the first control line to a bias power supply, a second switch that connects the first control line to the ground potential, a second control line connected in parallel to the second switching element, a capacitor that connects the second control line so as to correspond to a high frequency, and the second switch that connects the control line to the ground potential, and a switch for switching a local signal that shares the high frequency switch.

Owing to the configuration as described above, it is enabled, in the high frequency switch comprising the first control line connected in parallel to the signal line to supply a bias for controlling ON/OFF operation of the first switching element interposed in series in the signal line connecting the common terminal and a first terminal and of the second switching element loaded in parallel at portion 1/4 wavelength away from a branch point of a common terminal toward a second terminal, to connect the first control line to a bias power supply, to connect the first control line to the ground potential, to connect the second control line in parallel to the second switching element, to connect the second control line to the capacitor so as to correspond to a high frequency, to connect the control line to the ground potential, to commonly use the high frequency switch as a switch for switching a local signal; thereby it is enabled to switch the exciting path swiftly to change over the high frequency signal at a high speed.

The base station communication apparatus of the present invention is structured so as to comprise a high frequency switch comprising a first switching element interposed in series in a signal line connecting a common terminal and a first terminal, a second switching element loaded in parallel at portion 1/4 wavelength away from a branch point of a common terminal toward a second terminal, and a first control line connected in parallel to a first signal line to supply a bias for controlling ON/OFF operation of the first switching element, wherein the high frequency switch comprises a first switch that connect the first control line to a bias power supply, a second switch that connects the first control line to the ground potential, a second control line connected in parallel to the second switching element, a capacitor that connects the second control line so as to correspond to a high frequency, and the second switch that connects the control line to the ground potential, and a switch for switching a local signal that shares the high frequency switch.

Owing to the configuration as described above, it is enabled, in the high frequency switch comprising the first control line connected in parallel to the signal line to supply a bias for controlling ON/OFF operation of the first switching element interposed in series in the signal line connecting the common terminal and a first terminal and of the second switching element loaded in parallel at portion 1/4 wavelength away from a branch point of a common terminal toward a second terminal, to connect the first control line to a bias power supply, to connect the first control line to the ground potential, to connect the second control line in parallel to the second switching element, to connect the second control line to the capacitor so as to correspond to a high frequency, to connect the control line to the ground potential, to commonly use the high frequency switch as a switch for switching a local signal; thereby it is enabled to switch the exciting path swiftly to change over the high frequency signal at a high speed.

The control station communication apparatus of the present invention can be structured so as to comprise a high frequency switch comprising a first switching element interposed in series in a signal line connecting a common terminal and a first terminal, a second switching element loaded in parallel at portion 1/4 wavelength away from a branch point of a common terminal toward a second terminal, and a first control line connected in parallel to the signal line to supply a bias for controlling ON/OFF operation of the first switching element, wherein the high frequency switch comprises a first switch that connects the first control line to a bias power supply, a second switch that connects the first control line to the ground potential, a second control line connected in parallel to the second switching element, a capacitor that connects the second control line so as to correspond to a high frequency, and a second switch that connects the control line to the ground potential, and a switch for switching a local signal that commonly uses the high frequency switch.

Owing to the configuration as described above, it is enabled, in the high frequency switch comprising the first control line connected in parallel to the signal line to supply a bias for controlling ON/OFF operation of the first switching element interposed in series in the signal line connecting the common terminal and the first terminal, and of the second switching element loaded in parallel at portion 1/4 wavelength away from a branch point of a common terminal toward the second terminal, to connect the first control line to a bias power supply, to connect the first control line to the ground potential, to connect a second control line to the second switching element, to connect the second control line to the capacitor so as to correspond to a high frequency, to connect the control line to the ground potential, to use the high frequency switch also as a switch for switching a local signal; thereby it is enabled to switch the exciting path swiftly to change over the high frequency signal at a high speed.

As described above, according to the present invention, it is enabled to provide a communication apparatus and a communication method which is capable of switching the exciting path swiftly and of performing a changeover of a high frequency signal at a high speed.

This application is based on the Japanese Patent Application No.2000-256040 filed on August 25, 2000, entire content of which is expressly incorporated by reference herein.

### Industrial Applicability

The present invention is applicable to a communication apparatus and a communication method provided with a high frequency switch which are used for various high frequency radio apparatus, communication equipment, measuring equipment or the like.

## Claims

1. A communication apparatus comprising a high frequency switch that comprises switches loaded in parallel at the respective portions a predetermined wavelength away, respectively, from a branch point of a common terminal toward respective terminals, and control lines connected in parallel to respective signal lines to supply a bias, respectively, for controlling ON/OFF operation of said switches;
wherein said high frequency switch comprises a first switch and a second switch that connect control lines to a bias power supply, and a third switch and a fourth switch that connect said control lines to the ground potential.

2. A communication apparatus comprising a high frequency switch that comprises a first switching element and a second switching element loaded in parallel at portions 1/4 wavelength away, respectively, from a branch point of a common terminal toward a first terminal and a second terminal respectively, and a first control line and a second control line connected in parallel to each signal line to supply a bias, respectively, for controlling ON/OFF operation of said first switching element and said second switching element;
wherein said high frequency switch comprises a first switch and a second switch that connect said first control line and said second control line to a bias power supply, and a third switch and a fourth switch that connect said first control line and second control line to the ground potential.

3. A communication apparatus comprising a high frequency switching apparatus which comprises a first switching element interposed in series in a signal line connecting a common terminal and a first terminal, a second switching element interposed in series in a signal line connecting said common terminal and a second terminal, and a first control line and a second control line connected in parallel to each signal line to supply a bias, respectively, for controlling ON/OFF operation of said first switching element and said second
wherein said high frequency switching apparatus comprises a first switch and a second switch that connect said first control line and said second control line to a bias power, and a third switch and a fourth switch that connect said first control line and said second control line to the ground potential.

4. A communication apparatus comprising a high frequency switch that comprises a first switching element interposed in series in a signal line connecting a common terminal and a first terminal, a second switching element loaded in parallel at portion 1/4 wavelength away from a branch point of a common terminal toward a second terminal, and a first control line connected in parallel to said signal line to supply a bias for controlling ON/OFF operation of said first switching element;
wherein said high frequency switch comprises a first switch that connects a first control line to a bias power supply, a second switch that connects said first control line to the ground potential, a second control line connected in parallel to the second switching element, a capacitor that grounds said second control line in a manner of high frequency, and a second switch that connects said control line to the ground potential.

5. A communication apparatus comprising a high frequency. switch that comprises a first switching element interposed in series in a signal line connecting a common terminal and a first terminal, a second switching element loaded in parallel at portion 1/4 wavelength away from a branch point of the common terminal toward a second terminal, and a first control line connected in parallel to said signal line to supply a bias for controlling ON/OFF operation of said first switching element;
wherein said high frequency switch comprises a first switch that connects said first control line to a bias power supply, a second switch that connects said first control line to the ground potential, a second control line connected in parallel to said second switching element, a capacitor that connects said second control line so as to correspond to a high frequency, a second switch that connects said control line to the ground potential, and transmission/reception changeover means that commonly uses said high frequency switch.

6. A communication apparatus comprising a high frequency switch that comprises a first switching element interposed in series in a signal line connecting a common terminal and a first terminal, a second switching element loaded in parallel at portion 1/4 wavelength away from a branch point of the common terminal toward a second terminal, and a first control line connected in parallel to said signal line to supply a bias for controlling ON/OFF operation of said first switching element;
wherein said high frequency switch comprises a first switch that connects a first control line to a bias power supply, a second switch that connects said first control line to the ground potential, a second control line connected in parallel to said second switching element, a capacitor that connects said second control line so as to correspond to a high frequency; a second switch that connects said control line to a ground potential, and a switch for switching a local signal that commonly uses said high frequency switch.

7. A mobile station communication apparatus comprising a high frequency switch that comprises a first switching element interposed in series in a signal line connecting a common terminal and a first terminal, a second switching element loaded in parallel at portion 1/4 wavelength away from a branch point of said common terminal toward a second terminal, and a first control line connected in parallel to said signal line to supply a bias for controlling ON/OFF operation of said first switching element;
wherein said high frequency switch comprises a first switch that connects a first control line to a bias power supply, a second switch that connects said first control line to the ground potential, a second control line connected in parallel to said second switching element, a capacitor that connects said second control line so as to correspond to a high frequency, and a second switch that connects said control line to the ground potential, and a switch for switching a local signal that commonly uses said high frequency switch.

8. A base station communication apparatus comprising a high frequency switch that comprises a first switching element interposed in series in a signal line connecting a common terminal and a first terminal, a second switching element loaded in parallel at portion 1/4 wavelength away from a branch point of the common terminal toward a second terminal, and a first control line connected in parallel to said signal line to supply a bias for controlling ON/OFF operation of said first switching element;
wherein said high frequency switch comprises a first switch that connects said first control line to a bias power supply, a second switch that connects said first control line to the ground potential, a second control line connected in parallel to said second switching element, a capacitor that connects said second control line so as to correspond to a high frequency, and a second switch that connects said control line to the ground potential, and a switch for switching a local signal that commonly uses said high frequency switch.

9. A control station communication apparatus comprising a high frequency switch that comprises a first switching element interposed in series in a signal line connecting a common terminal and a first terminal, a second switching element loaded in parallel at portion 1/4 wavelength away from a branch point of the common terminal toward a second terminal, and a first control line connected in parallel to said signal line to supply a bias for controlling ON/OFF operation of said first switching element;
wherein said high frequency switch comprises a first switch that connects said first control line to a bias power supply, a second switch that connects said first control line to the ground potential, a second control line connected in parallel to said second switching element, a capacitor that connects said second control line so as to correspond to a high frequency, and a second switch that connects said control line to the ground potential and a switch for switching a local signal that commonly uses said high frequency switch.

10. A high frequency switch circuit utilizing a bipolar element in which a plurality of signal paths are connected in parallel to a high frequency signal input terminal, thereby input impedance of any one of said plurality of signal paths is made into low impedance by controlling ON/OFF operation of a switching diode provided to each signal path, and a signal transmission path is selectively switched by guiding said high frequency signal to said signal path having said low impedance;
wherein said high frequency switch circuit utilizing a bipolar element comprises a pull-down circuit provided to each switching diode to forcibly pull out residual electric charge of each said switching diode provided to said each signal path.

11. A high frequency switch circuit utilizing a bipolar element in which a plurality of signal paths are connected in parallel to a high frequency signal input terminal, thereby input impedance of any one of said plurality of signal paths is made into low impedance by controlling ON/OFF operation of a switching diode provided to each signal path, and signal transmission path is selectively switched by guiding said high frequency signal to said signal path having said low impedance;
wherein said high frequency switch circuit utilizing a bipolar element comprises:
a bias transistor provided corresponding to each of said switching diodes in order to turn ON each of said switching diodes provided to said each signal path;
a pull-down transistor provided corresponding to each of said switching diodes in order to forcibly pull out accumulated electric charge of said each switching diodes provided to said each signal path; and
an active element that inverts the level of a control signal for turning ON/OFF each of said bias transistors and drives each of said pull-down transistors by means of the signal having inverted level.

12. In claim 11, a pair of said bias transistor and pull-down transistor comprises a bipolar transistor connected in a manner of totem pole connection.

13. In claim 11, each of said switching diodes are provided at position 1/4 wavelength away of a major signal which passes through each of said signal paths from said high frequency signal input terminal.
